Europäisches Patentamt

European Patent Office

Office européen des brevets

(11) Publication number: 0 382 985
A1

# EUROPEAN PATENT APPLICATION

(21) Application number: 89400389.6

(51) Int. Cl.5: B01J 3/00, C23C 16/00

(22) Date of filing: 13.02.89

(43) Date of publication of application:
22.08.90 Bulletin 90/34

(84) Designated Contracting States:
FR

(71) Applicant: L'AIR LIQUIDE, SOCIETE ANONYME
POUR L'ETUDE ET L'EXPLOITATION DES
PROCEDES GEORGES CLAUDE
75, Quai d'Orsay
F-75321 Paris Cédex 07(FR)

(72) Inventor: Hirase, Ikuo
5-9-9 Tokodai
Toyosato-machi Tsucuba-Gun 300-26(JP)

(74) Representative: Vesin, Jacques et al
L'AIR LIQUIDE, SOCIETE ANONYME POUR
L'ETUDE ET L'EXPLOITATION DES
PROCEDES GEORGES CLAUDE 75, quai
d'Orsay
F-75321 Paris Cédex 07(FR)

(54) Gas purge system.

(57) A gas purge system includes a main line (4), a purging supply line (7) having a first valve (6) and a purging gas exhaust line (9) having a second valve (8), a vacuum pump mounted (10) on the purging gas exhaust line (9), and a pressure gauge (11), mounted on a suction side of the vacuum pump (10) of the purging gas exhaust line (9), for supplying a signal for closing the second valve (8) and opening the first valve (6) when the pressure in the purging gas exhaust line (9) reaches a predetermined value by evacuation of the vacuum pump (10). The first and second valves (6, 8) are alternately, repeatedly opened/closed by a signal from the pressure gauge (11), thereby preventing reverse diffusion of an oil from the vacuum pump (10) into the line. The gas purge system can purge gas in the line in a very short time period without contaminating the line.

F I G. 2

## Gas purge system

The present invention relates to a gas purge system and, more particularly, to an improved gas purge system for efficiently purging toxic or corrosive gases.

Inorganic halides such as $WF_6$, $MoF_6$, $TiCl_4$ and $BCl_3$, acidic compounds such as $HFSO_2$ and $H_2S$, alkaline compounds such as $HN_3$, and inorganic hydrides such as $SiH_4$ and $PH_3$ are widely used as materials for thin film formation by, e.g., CVD in a semiconductor manufacturing process. These compounds have come to be used increasingly in recent years with the rapid development of the semiconductor industry.

The gases noted above are, however, toxic or corrosive and therefore must be purged from lines beforehand when, e.g., a cylinder is to be exchanged. Such gas purging has been conventionally performed as follows.

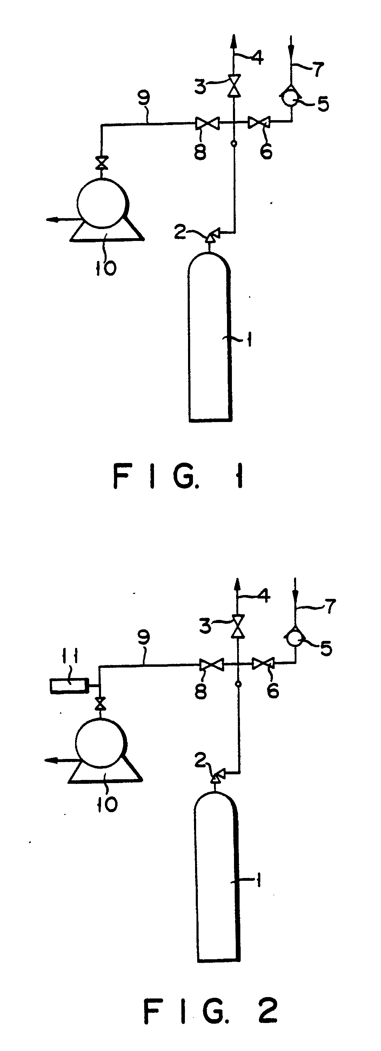

In Fig. 1, cylinder 1 is connected to main line 4 having valve 3 through L-shaped valve 2 mounted at its distal end. Line 4 is connected to line 7, having check valve 5 and valve 6, for supplying an inert gas such as nitrogen or argon as a purging gas and to line 9, having valve 8, for exhausting the purging gas. Line 9 is connected to vacuum pump 10. In such a line system, the gas in the lines is purged as follows.

That is, while valves 2, 3 and 6 are kept closed, valve 8 is opened and the vacuum pump is activated to reduce the pressure in the line to be, e.g., $10^{-2}$ Torr. Then, valve 8 is closed and valve 6 is opened to supply a purging gas. When the pressure in the line is increased to be a predetermined value upon supply of the purging gas, valve 6 is closed and valve 8 is opened to evacuate the line. The line is purged by repeating such an operation several times.

In such a method using the vacuum pump, however, an oil in the vacuum pump is reversely diffused in the line to contaminate it. That is, when the pressure in the line reaches a vapour pressure of the oil by evacuation, the oil is reversely diffused.

This contamination of the line with the oil leads to a detrimental effect on fabrication of semiconductors, for example a rapid reduction in deposition rate of W in depositing W using $WF_6$ and hydrogen by CVD.

It is an object of the present invention to provide a gas purge system capable of easily and efficiently purging air or gas in a line without contaminating the line.

According to the present invention, there is provided a gas purge system comprising a main line, a purging gas supply line having a first valve and a purging gas exhaust line having a second valve, a vacuum pump mounted on the purging gas exhaust line, and a pressure gauge, mounted on a suction side of the vacuum pump of the purging gas exhaust line, for supplying a signal for closing the second valve and opening the first valve when the pressure in the purging gas exhaust line reaches a predetermined value by evacuation of the vacuum pump.

In the gas purge system of the present invention, the pressure gauge is mounted at the suction side of the vacuum pump of the purging gas exhaust line. When the pressure in the purging gas exhaust line reaches a predetermined value by evacuation of the vacuum pump, the pressure gauge generate a signal for closing the valve of the purging gas exhaust line and opening the valve of the purging gas supply line. Examples of the pressure gauge having the above function are a pressure gauge with a contact and a pressure sensor. More specifically, a Pirani gauge or a Baratron can be used as the pressure gauge. In this case, the predetermined pressure value is smaller than the value of a vapour pressure of the oil used in the vacuum pump and is $10^{-2}$ Torr or more, e.g., $10^{-2}$ Torr or $10^{-1}$ Torr.

By closing the valve of the purging gas exhaust line and opening the valve of the purging gas supply line, a purging gas is supplied in the line. After the purging gas is supplied for 0.1 to 2 seconds, the valve of the purging gas supply line is closed and the valve of the purging gas exhaust line is opened, and then the vacuum pump evacuates the line again. This operation is repeatedly performed.

Supply of the purging gas may be stopped in accordance with a pressure instead of a time as described above. In this case, when the pressure in the purging gas exhaust line reaches a predetermined value upon supply of the purging gas, the pressure gauge generates a signal for closing the valve of the purging gas supply line and opening the valve of the purging gas exhaust line. The predetermined value of pressure is preferably 100 to 200 Torr.

The valves of the purging gas exhaust and supply lines can be easily, alternately opened/closed in accordance with a predetermined sequence and therefore can be controlled by a computer.

According to the gas purge system of the present invention, air or gas in the line can be easily and efficiently purged without contaminating the line. In particular, by controlling the pressure gauge for generating the opening/closing signal and the two valves in accordance with the predetermined sequence by a computer, the purging operation can be efficiently performed in a short time period.

This invention can be more fully understood from the following detailed description when taken in conjunction with the accompanying drawings, in which:

Fig. 1 is a flowchart showing a conventional gas purge system;

Fig. 2 is a flowchart showing a gas purge system according to one embodiment of the present invention;

Fig. 3 is a sectional view showing a gas purge assembly used in another embodiment of the present invention; and

Fig. 4 is a flowchart showing a gas purge system adopting the gas purge assembly shown in Fig. 3.

Embodiments of the present invention will be described below with reference to the accompanying drawing.

Fig. 2 is a flowchart showing a gas purge system according to one embodiment of the present invention. In Fig. 2, a pressure gauge with a contact is mounted at a suction side of a vacuum pump of purging gas exhaust line 9. When the pressure in line 9 is reduced to be a predetermined value, e.g., 10 Torr, the pressure gauge generates a signal for closing valve 8 and opening valve 6.

That is, the gas purge system shown in Fig. 2 has the same arrangement as that shown in Fig. 1 except that pressure gauge 11 is mounted on line 9 and controlled in association with the two valves.

The gas purge system shown in Fig. 2 performs a gas purging operation as follows. That is, while valves 2, 3 and 6 are kept closed, valve 8 is opened and the vacuum pump is activated to evacuate the line. When the pressure in the line be-comes $10^{-2}$ Torr, a contact of gauge 11 operates to close valve 8 and open valve 6. As a result, a purging gas is supplied from purging gas supply line 7. After the purging gas is supplied for a predetermined time interval, e.g., one second, valve 6 is closed and valve 8 is opened so that the line is evacuated again. Such an operation is repeated several times, e.g., ten times to purge the line.

According to the above purging operation, the pressure in the line is not reduced below a vapour pressure of an oil in the vacuum pump. Therefore, the oil is not reversely diffused from the vacuum pump into the line, thereby preventing contamination of the line.

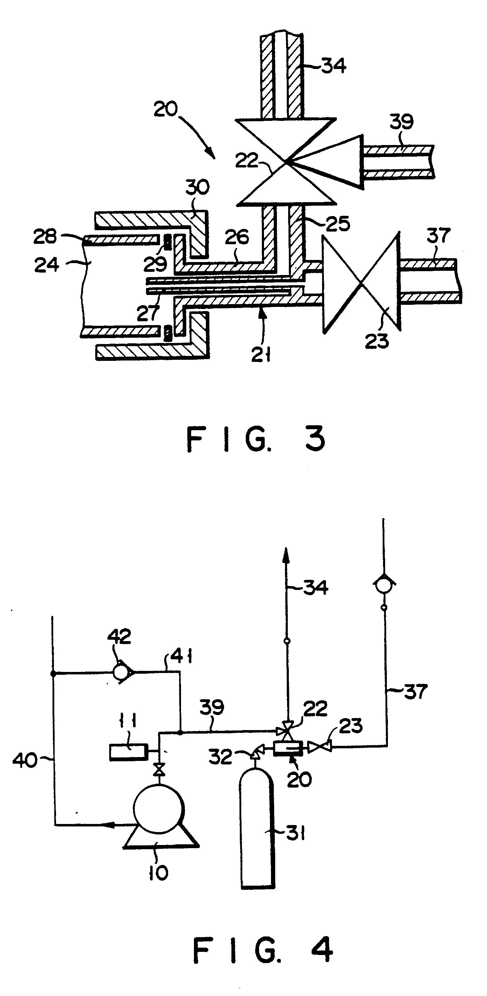

When the gas purge system of the present invention adopts a gas purge assembly as shown in Fig. 3, it can achieve more efficient gas purging. A gas purge system adopting such a gas purge assembly is shown in Fig. 4.

In Fig. 3, gas purge assembly 20 comprises joint assembly 21, and 3 ports valve 22 and valve 23 connected to joint assembly 21. Valves 22 and 23 are electrically or mechanically interlocked with each other so that the two valves can be simultaneously operated by a single operation. Assembly 21 has a double-pipe structure consisting of outer pipe 26 opened at its one end in cylinder connection portion 24, closed at the other end thereof, and having 3 ports valve connection pipe 25 communicating with its side portion, and inner pipe 27, arranged coaxially with outer pipe 26 and having one end extending in connection portion 24 and the other end communicating with pipe 37 through valve 23. The first connection port of valve 22 is connected to connection pipe 35, its second connection port is connected to main line 34 for flowing a gas from a cylinder (not shown), and its third connection port is connected to purging gas exhaust line 39. In Fig. 3, reference numeral 28 denotes a connection port of L-shaped valve 32 mounted on cylinder 31; 29, a packing; and 30, a clamping metal piece for connecting joint assembly 21 to connection port 28.

In the line system adopting the gas purge assembly described above, a purging operation can be performed similarly to the above embodiment.

In the gas purge assembly shown in Fig. 3, one end of inner pipe 27 communicating with purging gas supply line 37 extends in connection portion 24. Therefore, a purging gas such as nitrogen or argon from line 37 can be supplied deep in connection portion 27 and then exhausted through outer pipe 26. For this reason, residual air in connection portion 24 can be purged without forming a dead space. In addition, since 3 ports valve 22 is directly connected to joint assembly 21, the distance between L-shaped valve 32 mounted on cylinder 32 and valve 22 is very short. Therefore, the line can be efficiently purged.

In the gas purge system shown in Fig. 4, purge gas exhaust line 39 is connected to line 40 on the delivery side of vacuum pump 10 by means of line 41 having check valve 42. In such an arrangement, when the third connection port of 3 port valve 22 and L-shaped valve 32 is opened, a high pressure is impressed to line 39. This high pressure escapes from line 39 to line 41. As a result, a damage of vacuum pump 10 is prevented.

**Claims**

1. A gas purge system comprising a main line (4), a purging gas supply line (7) having a first valve (6) and a purging gas exhaust line (9) having a second valve (8), a vacuum pump (10) mounted on said purging gas exhaust line (9), and a pressure gauge (11), mounted on a suction side of said vacuum pump (10) of said purging gas exhaust line (9), for supplying a signal for closing said second valve (8) and opening said first valve (6) when the pressure in said purging gas exhaust line (9) reaches a predetermined value by evacuation of said vacuum pump (10).

2. A system according to claim 1, characterized in that said pressure gauge (11) comprises a pressure gauge with a contact or a pressure sensor.

3. A system according to claim 2, characterized in that said pressure gauge (11) comprises a Pirani gauge or a baratron.

4. A system according to claim 1, characterized in that the predetermined pressure value is smaller than a value of a vapour pressure of an oil used in said vacuum pump (10).

5. A system according to claim 1, characterized in that the predetermined pressure value is not less than $10^{-2}$ Torr.

6. A system according to claim 1, characterized in that said pressure gauge (11) generates a signal for closing said first valve and opening said second valve when the pressure in said purging gas exhaust line (9) reaches a predetermined value upon supply of a purging gas.

7. A system according to claim 1, characterized in that the predetermined value of pressure is not less than 100 Torr.

F I G. 1

F I G. 2

EP 0 382 985 A1

F I G. 3

F I G. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 11, no. 381 (C-464)[2828], 12th December 1987; & JP-A-62 152 529 (HITACHI LTD) 07-07-1987 * Abstract * ----- | 1 | B 01 J    3/00 C 23 C   16/00 |
| | | | TECHNICAL FIELDS SEARCHED (Int. Cl.5) |
| | | | B 01 J C 23 C |

The present search report has been drawn up for all claims

| Place of search | Date of completion of the search | Examiner |
|---|---|---|
| THE HAGUE | 30-10-1989 | BOGAERTS M.L.M. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.....................................................................................
& : member of the same patent family, corresponding
    document

EPO FORM 1503 03.82 (P0401)